(19) **Europäisches Patentamt / European Patent Office / Office européen des brevets**

(11) **EP 3 506 377 B1**

(12) **FASCICULE DE BREVET EUROPEEN**

(45) Date de publication et mention
de la délivrance du brevet:
**01.04.2026  Bulletin 2026/14**

(51) Classification Internationale des Brevets (IPC):
*H10B 63/00* (2023.01)    *H10N 70/20* (2023.01)
*H10N 70/00* (2023.01)

(21) Numéro de dépôt: **18215849.3**

(22) Date de dépôt: **24.12.2018**

(52) Classification Coopérative des Brevets (CPC):
**H10B 63/24; H10B 63/20; H10B 63/84;
H10N 70/231; H10N 70/826; H10N 70/841;
H10N 70/8825; H10N 70/8828**

(54) **CELLULE ELEMENTAIRE COMPORTANT UNE MEMOIRE RESISTIVE ET UN SELECTEUR, ETAGE ET MATRICE D'ETAGES COMPORTANT UNE PLURALITE DE CES CELLULES ET PROCEDE DE FABRICATION ASSOCIE**

ELEMENTARZELLE, UMFASSEND EINEN WIDERSTANDSSPEICHER UND EIN AUSWAHLELEMENT, EBENE UND MATRIX VON EBENEN UMFASSEND EINE VIELZAHL SOLCHER ZELLEN SOWIE ZUGEORDNETES HERSTELLUNGSVERFAHREN

ELEMENTARY CELL COMPRISING A RESISTIVE MEMORY AND A SELECTION ELEMENT, LEVEL AND MATRIX OF LEVELS COMPRISING A PLURALITY OF SUCH CELLS AND ASSOCIATED METHOD OF FABRICATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **26.12.2017  FR 1763208**

(43) Date de publication de la demande:
**03.07.2019  Bulletin 2019/27**

(73) Titulaire: **Commissariat à l'Energie Atomique et aux Energies Alternatives
75015 Paris (FR)**

(72) Inventeur: **NAVARRO, Gabriele
38000 Grenoble (FR)**

(74) Mandataire: **Cabinet Camus Lebkiri
25 rue de Maubeuge
75009 Paris (FR)**

(56) Documents cités:
WO-A1-2016/043657    US-A1- 2010 227 438
US-A1- 2013 270 507    US-A1- 2014 312 296

**Description**

**DOMAINE TECHNIQUE DE L'INVENTION**

Le domaine technique de l'invention est celui des mémoires résistives non volatiles. La présente invention concerne une cellule élémentaire comportant une mémoire résistive et un sélecteur, un étage comportant une pluralité de ces cellules et une matrice comportant une pluralité de ces étages. La présente invention concerne également le procédé de fabrication permettant d'obtenir cet étage et cette matrice.

**ARRIERE-PLAN TECHNOLOGIQUE DE L'INVENTION**

Pour des applications qui nécessitent un stockage de l'information même lorsque la tension est coupée, des mémoires non volatiles de type EEPROM ou FLASH qui réalisent un stockage de charges sur des grilles flottantes de transistors à effet de champ, sont classiquement utilisées. Ces mémoires présentent toutefois des inconvénients :

- temps d'écriture longs (quelques microsecondes),
- densité limitée car la réduction de la taille des transistors conduit à une diminution du signal de lecture, c'est-à-dire une baisse de la différence entre les deux états du point mémoire, et une réduction de la durée de rétention de l'information,
- nombre de cycles d'écriture limité car la capacité de rétention de l'information diminue au fur et à mesure des cycles d'écriture à cause de la création de défauts dans l'oxyde de grille des transistors, permettant aux électrons de s'échapper de la grille flottante.

Ainsi, ce type de mémoires ne présente pas les caractéristiques requises pour supporter le développement de nouvelles technologies telles que les mémoires SCM (pour « Storage Class Memory ») qui connaissent un essor important notamment grâce à leur capacité à augmenter les performances des ordinateurs tout en réduisant leur consommation.

Plus récemment, d'autres types de mémoires non volatiles réinscriptibles sont apparus, basés sur des matériaux actifs tels que des matériaux à conduction ionique (mémoires CBRAM ou « Conductive Bridging RAM »), à oxydes métalliques (mémoires OxRAM ou « Oxide Resistive RAM »), ferroélectriques (mémoires FERAM ou « Ferroelectric RAM »), magnétiques (mémoires MRAM ou « Magnetic RAM), magnétiques à transfert de spin (mémoires STTRAM ou « Spin Torque Transfer RAM ») ou encore à changement de phase (mémoires PCRAM ou « Phase Change RAM »). Ces mémoires sont des mémoires de type résistive (c'est-à-dire qu'elles peuvent présenter au moins deux états « OFF » ou « ON » correspondant au passage d'un état résistif (état « OFF ») à un état moins résistif (état « ON »)).

Les mémoires résistives ont besoin de deux électrodes pour fonctionner. Par exemple, les mémoires CBRAM comportent une zone active basée sur un matériau à conduction ionique formant un électrolyte solide à conduction ionique disposé entre une électrode formant une cathode inerte et une électrode comportant une portion de métal ionisable, c'est-à-dire une portion de métal pouvant facilement former des ions métalliques, et formant une anode. Le fonctionnement des mémoires CBRAM est basé sur la formation, au sein de l'électrolyte solide, d'un ou plusieurs filaments métalliques (appelés également « dendrites ») entre ses deux électrodes lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes.

Les mémoires PCRAM comportent une zone active basée sur un matériau chalcogénure. Le fonctionnement des mémoires PCRAM est basé sur la transition de phase du matériau chalcogénure, induite par l'échauffement de ce matériau sous l'effet d'impulsions électriques spécifiques générées par ses deux électrodes. Cette transition se fait entre une phase cristalline, ordonnée, de faible résistance et thermodynamiquement stable et une phase amorphe, désordonnée, de résistance élevée et thermodynamiquement instable.

Les mémoires résistives présentent notamment l'intérêt de pouvoir s'intégrer avec de fortes densités, via une intégration de type « cross-bar » (désignée également par la terminologie « cross-point »).

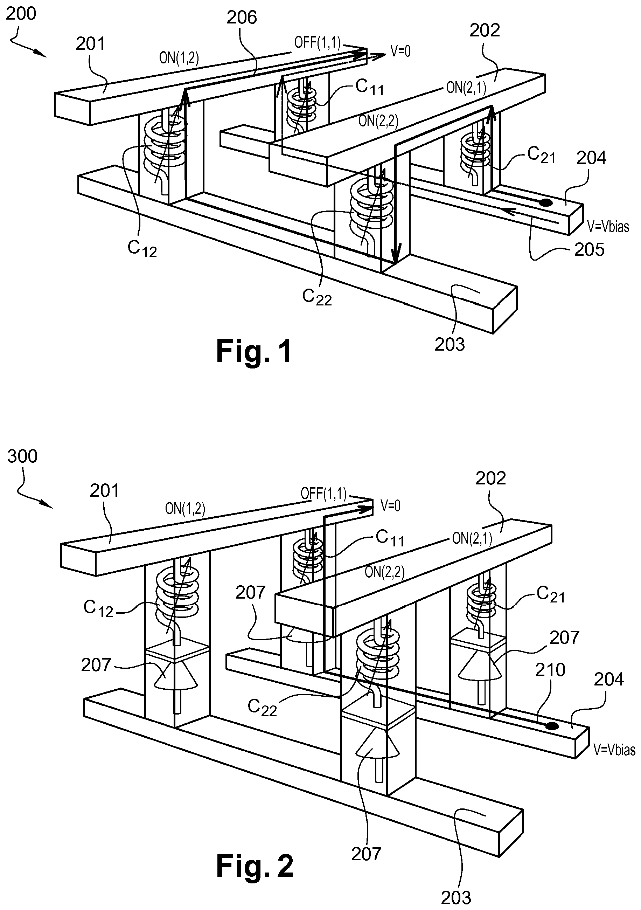

Une telle architecture 200 est illustrée sur la figure 1 et comporte une pluralité de lignes d'accès 201, 202, 203 et 204 et une pluralité de cellules mémoires (ici quatre cellules C11, C21, C22 et C12) de type non volatiles réinscriptibles basées sur des matériaux actifs (par exemple des cellules CBRAM). Les lignes d'accès sont formées par des lignes de bits 201 et 202 parallèles supérieures et des lignes de mots 203 et 204 inférieures perpendiculaires aux lignes de bits, les cellules élémentaires C11, C21, C22 et C12 étant prises en sandwich à l'intersection entre les lignes de bits 201 et 202 et les lignes de mots 203 et 204. L'architecture 200 forme ainsi un réseau où chaque cellule mémoire est adressable individuellement, en sélectionnant la bonne ligne de bits et la bonne ligne de mots.

Ce type d'architecture présente toutefois certains inconvénients. Ainsi, la phase de lecture de l'état d'une cellule est réalisée par la polarisation de la ligne et de la colonne souhaitées ; il est alors possible d'observer un courant de fuite parasite passant par les cellules adjacentes. Nous faisons ici l'hypothèse que :

- La cellule C11 est à l'état OFF (état haute résistance) ;

- La cellule C21 est à l'état ON (état basse résistance) ;
- La cellule C22 est à l'état ON (état basse résistance) ;
- La cellule C12 est à l'état ON (état basse résistance).

La lecture de l'état résistif de la cellule C11 implique de polariser respectivement la ligne de bits 201 et la ligne de mots 204 (application d'une différence de potentiel Vbias entre ces deux lignes). En théorie, le courant de mesure devrait circuler uniquement selon la flèche 205 représentée en pointillés. En pratique, du fait que les trois autres cellules sont à l'état ON, un courant de fuite parasite, représenté par la flèche 206, passe par les cellules non résistives C21, C22 et C12. Ce courant de fuite, en particulier dans le cas défavorable où les éléments adjacents de la cellule à mesurer sont à l'état ON, peut perturber la mesure jusqu'à empêcher la discrimination entre l'état ON et l'état OFF de la cellule à mesurer.

Une solution connue à ce problème consiste à rajouter, en série avec chacune des cellules, une diode à jonction p/n 207 pour jouer le rôle de sélecteur. Une telle architecture 300 est illustrée en figure 2. Les éléments communs portent les mêmes numéros de référence sur les figures 1 et 2, étant entendu que les cellules C11, C21, C22 et C12 de la figure 2 sont dans le même état résistif que les cellules C11, C21, C22 et C12 de la figure 1. Dans ce cas, les diodes 207 étant unipolaires, elles bloquent le passage du courant parasite, autorisant ainsi uniquement le courant représenté par la flèche 210 induit par la polarisation de la ligne de bits 201 et la ligne de mots 204 (application d'une différence de potentiel Vbias entre ces deux lignes).

L'architecture telle qu'illustrée en figure 2 pose toutefois également certaines difficultés liées en particulier au fait que les diodes présentent des intensités de courant en mode passant qui restent limitées. Ainsi, actuellement, pour une surface de silicium donnée, il n'est pas possible de réaliser une diode de même surface que la cellule mémoire et ayant un courant passant $I_{ON}$ suffisant (densité de courant des diodes trop faible) et dans le même temps un courant de fuite $I_{OFF}$ assez faible. Une telle situation pose notamment de sérieuses difficultés dans le cas de l'utilisation d'une diode en série avec une cellule de type à changement de phase PCRAM qui nécessite des courants de commutation importants.

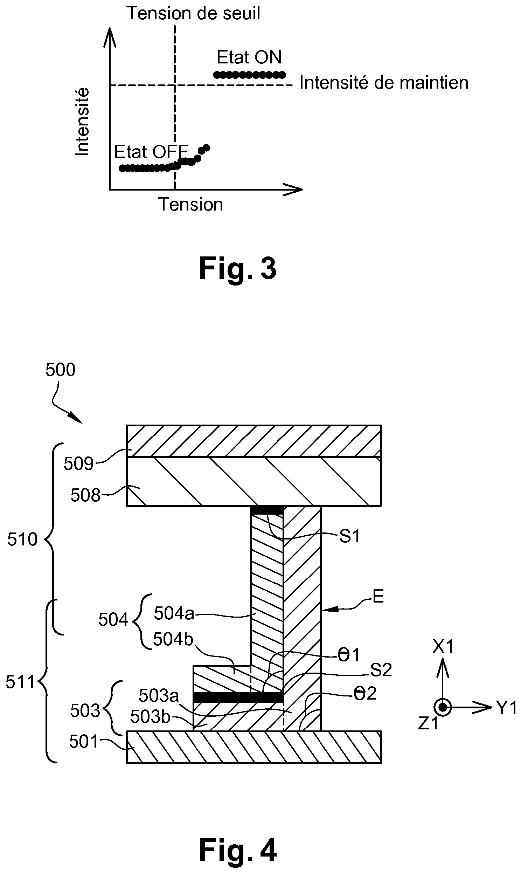

C'est pourquoi plusieurs solutions alternatives ont été étudiées ces dernières années. Dans la littérature, on retrouve différents types de sélecteur comme les FAST (pour « Field Assisted Superlinear Threshold »), les MIEC (pour « Mixed-Ionic-Electronic Conduction ») et les OTS (pour « Ovonic Threshold Switching »). Un dispositif sélecteur est composé de deux électrodes et d'un matériau actif, les électrodes étant disposées de part et d'autre du matériau actif et permettant d'appliquer une tension à ce matériau actif. Dans le cas d'un sélecteur de type OTS, le matériau actif peut être un alliage chalcogène. Le principe de base du fonctionnement d'un dispositif sélecteur est représenté à la figure 3. Le dispositif est très résistif dans l'état OFF. Dès qu'on lui applique une tension supérieure à une tension de seuil, le courant augmente rapidement pour atteindre l'état ON du dispositif, un état bassement résistif. Dès que le courant ou la tension est réduit au-dessous d'une valeur spécifique dite de maintien ou de « holding », le dispositif redevient OFF.

Pour pouvoir être intégré avec une mémoire résistive, un sélecteur doit présenter plusieurs spécificités. En effet, il doit avoir :

- une dimension proche de celle de la mémoire co-intégrée ;
- un faible courant de fuite $I_{OFF}$ : quand le sélecteur est dans son état « OFF » donc à faible champ, la résistance du sélecteur doit être très élevée. Cette caractéristique est atteignable en réduisant, par exemple, la surface de contact entre le sélecteur et son électrode supérieure ou en augmentant l'épaisseur du matériau actif du sélecteur, l'épaisseur du matériau actif du sélecteur étant la dimension du matériau actif du sélecteur selon une direction orthogonale au plan formé par la surface de contact entre le sélecteur et son électrode supérieure ;
- une faible tension de seuil : ceci est obtenu en réduisant au contraire l'épaisseur du matériau actif du sélecteur.

Pour améliorer encore la densité d'intégration des mémoires résistives, une solution classique est de diminuer la taille de la surface entre le matériau actif de la mémoire résistive et son électrode inférieure pour permettre une réduction du courant de programmation de la mémoire résistive.

En général donc, à la fois pour le dispositif de mémoire et pour le sélecteur, la réduction de la surface, notamment la surface de contact entre le sélecteur et son électrode supérieure et la surface de contact entre le matériau actif de la mémoire et son électrode inférieure, permet de répondre à toutes les caractéristiques recherchées à savoir :

- la réduction de la taille du dispositif complet que nous désignerons par la suite par le terme « cellule élémentaire » ;
- la réduction du courant de fuite $I_{OFF}$ ;
- la réduction du courant de programmation de la mémoire ;
- l'augmentation de la densité d'intégration de la mémoire.

L'intégration proposée dans cette invention est en particulier dédiée à la co-intégration entre mémoire PCRAM et sélecteur OTS, mais elle peut s'étendre à d'autres types de mémoires résistives comme les Ox-RAM ou les CBRAM et d'autres types de sélecteurs comme les FAST et les MIEC.

Une solution pour réduire à la fois la surface du sélecteur OTS et de la mémoire PCRAM est décrite dans le brevet US20150123066A1. On y propose de graver les deux dispositifs en même temps en réalisant des opérations lithographiques dans les deux directions du plan. Cette solution présente de nombreux désavantages dont les plus importants sont :

- le besoin d'une lithographie très agressive pour atteindre des courants de fuite et de programmation raisonnablement faibles ;
- un problème mécanique de stabilité des structures après gravure
- le besoin d'une chimie de gravure apte à graver les deux matériaux PCM et OTS, sans abîmer l'un pendant la gravure de l'autre, ce qui entraîne une limitation dans le choix de la composition des matériaux.

D'autres dispositifs et procédés de l'art antérieur sont décrits par US 2014 / 0312296 A1, US 2010 / 0227438 A1, US 2013 / 0270507 A1 et WO 2016 / 043657 A1.

Il existe donc un besoin de réduire les dimensions du sélecteur OTS et de réduire la surface de contact entre la mémoire PCRAM et son électrode inférieure au sein d'un dispositif présentant une architecture de type « cross-bar », sans que celui-ci ne rencontre de problèmes de stabilité à l'issue de sa fabrication et sans limiter le choix des matériaux le composant.

**RESUME DE L'INVENTION**

L'invention offre une solution aux problèmes évoqués précédemment, en proposant une cellule mémoire élémentaire adaptée pour être intégrée dans un dispositif avec une architecture de type « cross-bar » présentant un sélecteur et une surface de contact entre la cellule mémoire et son électrode inférieure de dimensions réduites par rapport aux structures « cross-bar » classiques tout en ne limitant pas le choix des matériaux et en ne dégradant pas la stabilité du dispositif final.

Un premier aspect de l'invention concerne une cellule élémentaire comportant une mémoire vive résistive non volatile montée en série avec un dispositif sélecteur telle que définie par la revendication 1.

Grâce à l'invention, les dimensions du dispositif sélecteur sont définies par :

- les dimensions de la seconde branche de l'élément conducteur monobloc ;
- l'épaisseur de la couche active sélectrice, c'est-à-dire la dimension de la couche active sélectrice selon une direction orthogonale au plan défini par la surface de contact entre la couche active sélectrice et la seconde branche de l'élément conducteur monobloc.

Les dimensions de la surface de contact entre la mémoire et son électrode inférieure sont définies par les dimensions de la première branche de l'élément conducteur monobloc.

Les dimensions des deux branches de l'élément conducteur monobloc étant indépendantes les unes des autres, les enjeux sur la réduction de la surface de contact entre la mémoire et son électrode inférieure sont séparés des enjeux de la réduction des dimensions du dispositif sélecteur, ce qui permet de ne pas limiter le choix des matériaux. De plus, cela évite d'avoir à graver la mémoire résistive et le dispositif sélecteur en même temps ce qui déstabiliseraient le dispositif final.

Outre les caractéristiques qui viennent d'être évoquées dans le paragraphe précédent, la cellule élémentaire selon un aspect de l'invention peut présenter une ou plusieurs caractéristiques complémentaires parmi les suivantes, considérées individuellement ou selon toutes les combinaisons techniquement possibles.

Avantageusement, le dispositif sélecteur comporte un élément sélecteur monobloc comportant :

- une première branche sensiblement en forme de parallélépipède rectangle, ladite première branche présentant une face en contact avec une face de la première branche de l'élément conducteur monobloc
- une seconde branche sensiblement en forme de parallélépipède rectangle constituée de la couche active sélectrice,

de manière à ce que l'élément sélecteur monobloc épouse les contours extérieurs de l'élément conducteur monobloc.

Ainsi, la première branche de l'élément sélecteur monobloc permet une meilleure isolation de l'élément conducteur monobloc.

Avantageusement, l'angle entre les deux branches de l'élément conducteur monobloc est sensiblement droit.

Selon l'invention, le dispositif sélecteur est de type OTS, FAST ou MIEC.

Avantageusement, la mémoire résistive est de type PCRAM, OxRAM ou CbRAM.

Avantageusement, un étage comporte une pluralité de cellules selon un premier aspect de l'invention réparties le long de plusieurs droites parallèles entre elles.

Avantageusement, une matrice comporte une pluralité d'étages agencés les uns sur les autres et la direction des droites selon lesquelles sont réparties les cellules d'un étage alternent d'un étage à l'autre de manière à ce que la direction des droites d'un étage soit perpendiculaire à la direction des droites de l'étage immédiatement en dessous et/ou au-dessus.

Ainsi, l'étage et la matrice d'étages permettent d'intégrer les mémoires résistives avec de fortes densités. De plus, cela permet une intégration compacte des cellules.

Un deuxième aspect de l'invention concerne un procédé de fabrication d'un étage comportant :

- une étape de dépôt conforme d'une couche de matériau conducteur d'électrode inférieure du dispositif sélecteur sur un substrat puis de dépôt conforme d'une première couche de matériau diélectrique sur la couche de matériau conducteur d'électrode inférieure du dispositif sélecteur ;
- une étape de gravure d'une pluralité de tranchées parallèles entre elles dans la première couche de matériau diélectrique avec arrêt sur la couche de matériau conducteur d'électrode inférieure du dispositif sélecteur ;
- une étape de dépôt conforme d'une couche active sélectrice afin de recouvrir les tranchées et les parties de la première couche de matériau diélectrique qui n'ont pas été gravées lors de l'étape de gravure, puis de dépôt conforme d'une couche de matériau d'élément conducteur monobloc sur la couche active sélectrice puis de dépôt conforme d'une deuxième couche de diélectrique sur la couche de matériau d'élément conducteur monobloc, de manière à ce que les tranchées ne soient pas comblées ;
- une étape de gravure anisotrope selon la direction des tranchées avec arrêt sur la couche de matériau conducteur d'électrode inférieure du dispositif sélecteur au fond des tranchées et avec arrêt sur les parties de la première couche de matériau diélectrique n'ayant pas été gravées lors de l'étape de gravure afin d'obtenir chaque élément conducteur monobloc des cellules élémentaires ;
- une étape de remplissage par une troisième couche de matériau diélectrique de manière à combler les tranchées ;
- une étape de lithographie réalisant plusieurs tranchées lithographiques suivant une direction perpendiculaire à la direction des tranchées précédemment gravées et dans le plan de la troisième couche de matériau diélectrique, avec arrêt sur le substrat ;
- une étape de remplissage par une quatrième couche de matériau diélectrique de manière à combler les tranchées lithographiques ;
- une étape de planarisation avec arrêt sur les parties de la première couche de matériau diélectrique n'ayant pas été gravées ;
- une étape de dépôt conforme d'une couche active mémoire puis de dépôt conforme d'une couche de matériau conducteur d'électrode supérieure de mémoire résistive sur la couche active mémoire.

Ainsi, le procédé selon un deuxième aspect de l'invention permet d'obtenir un étage de cellules selon un premier aspect de l'invention.

Avantageusement, un procédé de fabrication d'une matrice reprend les mêmes étapes que le procédé selon un deuxième aspect de l'invention pour chaque étage de la matrice de manière à ce que la direction des tranchées d'un étage soit perpendiculaire à la direction des tranchées de l'étage immédiatement en dessous et/ou au-dessus.

Ainsi, ce procédé permet d'obtenir une matrice d'étages de cellules selon un premier aspect de l'invention.

Avantageusement, un procédé de fabrication d'une matrice d'étages de cellules selon un premier aspect de l'invention comporte une étape de gravure de plusieurs tranchées finales selon la direction des tranchées gravées à l'étape de gravure de réalisation du dernier étage, gravure de tranchées finales dans la couche active mémoire et la couche de matériau conducteur d'électrode supérieure de mémoire résistive du dernier étage de manière à ne conserver la couche active mémoire et la couche de matériau conducteur d'électrode supérieure de mémoire résistive qu'au niveau des surfaces de contact entre la couche active mémoire et la couche de matériau d'élément conducteur monobloc.

Un troisième aspect de l'invention concerne un procédé de fabrication d'au moins une cellule élémentaire comportant une mémoire vive résistive non volatile montée en série avec un dispositif sélecteur volatile, ladite mémoire comportant :

- une électrode supérieure de la mémoire résistive,
- une électrode inférieure de la mémoire résistive,
- une couche réalisée dans un premier matériau actif, dite couche active mémoire,

ladite mémoire passant d'un état fortement résistif à un état faiblement résistif par application d'une tension seuil entre l'électrode supérieure de la mémoire résistive et l'électrode inférieure de la mémoire résistive, ledit dispositif sélecteur comportant :

- une électrode supérieure du dispositif sélecteur,
- une électrode inférieure du dispositif sélecteur,
- une couche réalisée dans un second matériau actif, dite couche active sélectrice,

ledit dispositif sélecteur passant d'un état fortement résistif à un état faiblement résistif par application d'une tension seuil entre l'électrode supérieure du dispositif sélecteur et l'électrode inférieure du dispositif sélecteur, ledit dispositif sélecteur repassant à l'état fortement résistif dès que le courant le traversant ou la tension aux bornes de l'électrode supérieure du dispositif sélecteur et l'électrode inférieure du dispositif sélecteur redevient respectivement inférieur à un courant ou une tension de maintien, le procédé étant caractérisée en ce qu'il comporte les étapes suivantes :

- une étape de dépôt conforme d'une couche de matériau conducteur d'électrode inférieure du dispositif sélecteur sur un substrat puis de dépôt conforme d'une première couche de matériau diélectrique sur la couche de matériau conducteur d'électrode inférieure du dispositif sélecteur ;

- une étape de gravure d'au moins une tranchée, tranchées parallèles entre elles, dans la première couche de matériau diélectrique avec arrêt sur la couche de matériau conducteur d'électrode inférieure du dispositif sélecteur;
- une étape de dépôt conforme d'une couche active sélectrice afin de recouvrir chaque tranchée et les parties de la première couche de matériau diélectrique qui n'ont pas été gravées lors de l'étape de gravure, puis de dépôt conforme d'une couche de matériau d'élément conducteur monobloc sur la couche active sélectrice puis de dépôt conforme d'une deuxième couche de diélectrique sur la couche de matériau d'élément conducteur monobloc, de manière à ce que chaque tranchée ne soit pas comblée ;
- une étape de gravure anisotrope selon la direction de la ou des tranchées avec arrêt sur la couche de matériau conducteur d'électrode inférieure du dispositif sélecteur au fond de la ou des tranchées et avec arrêt sur les parties de la première couche de matériau diélectrique n'ayant pas été gravées lors de l'étape de gravure afin d'obtenir au moins un élément conducteur monobloc ;
- une étape de remplissage par une troisième couche de matériau diélectrique de manière à combler les tranchées ;
- une étape de lithographie réalisant au moins une tranchée lithographique suivant une direction perpendiculaire à la direction de la ou des tranchées précédemment gravées et dans le plan de la troisième couche de matériau diélectrique, avec arrêt sur le substrat ;
- une étape de remplissage par une quatrième couche de matériau diélectrique de manière à combler la ou les tranchées lithographiques ;
- une étape de planarisation avec arrêt sur les parties de la première couche de matériau diélectrique n'ayant pas été gravées ;
- une étape de dépôt conforme d'une couche active mémoire puis de dépôt conforme d'une couche de matériau conducteur d'électrode supérieure de mémoire résistive sur la couche active mémoire.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 représente une première architecture d'adressage d'une pluralité de cellules mémoires selon l'état de la technique ;
- La figure 2 représente une deuxième architecture d'adressage d'une pluralité de cellules mémoires selon l'état de la technique ;
- La figure 3 montre un graphe explicitant le principe de fonctionnement d'un dispositif sélecteur.
- La figure 4 montre une représentation schématique 2D d'une cellule élémentaire électronique selon un premier aspect de l'invention.
- Les figures 5 à 14 illustrent les différentes étapes du procédé de fabrication d'un ou plusieurs étages intégrant une pluralité de cellules selon la figure 4.
- La figure 15 montre l'organigramme des étapes du procédé illustrées aux figures 5 à 14.

## DESCRIPTION DETAILLEE D'AU MOINS UN MODE DE REALISATION DE L'INVENTION

Sauf précision contraire, un même élément apparaissant sur des figures différentes présente une référence unique.

Les figures 1 à 3 ont déjà été décrites en référence à l'état de la technique.

Un premier aspect de l'invention illustré à la figure 4 concerne une cellule élémentaire 500 permettant l'adressage d'une mémoire résistive 510 non-volatile quand elle est intégrée au sein d'une architecture de type cross-bar.

La cellule élémentaire 500 comporte :

- Une couche de matériau conducteur d'électrode supérieure de mémoire résistive 509 ;
- Une couche réalisée dans un premier matériau actif, dite couche active mémoire 508 ;
- Un élément conducteur monobloc 504 comportant :

  • Une première branche 504a formant l'électrode inférieure de la mémoire résistive 510 ;
  • Une seconde branche 504b formant l'électrode supérieure du dispositif sélecteur 511 ;

- Un élément sélecteur monobloc 503 comportant :

  • Une première branche 503a ;
  • Une couche réalisée dans un second matériau actif, dite couche active sélectrice formant une seconde branche 503b ;

- Une couche de matériau conducteur d'électrode inférieure du dispositif sélecteur 501.

Le premier matériau actif est apte à former une mémoire résistive 510 et le second matériau actif est apte à former un dispositif sélecteur 511, le dispositif sélecteur 511 et la mémoire résistive 510 nécessitant chacun une électrode supérieure et une électrode inférieure pour assurer leur fonctionnement.

On définit une électrode supérieure d'un dispositif comme l'électrode située au-dessus de ce dispositif et l'électrode inférieure d'un dispositif comme l'électrode située en dessous de ce dispositif, les électrodes étant situées de part et d'autre du dispositif. Bien entendu, les adjectifs « supérieure » et « inférieure » sont ici relatifs à l'orientation de l'ensemble incluant l'électrode supérieure, le dispositif et l'électrode inférieure si bien qu'en retournant cet ensemble, l'électrode précédemment qualifiée de supérieure devient l'électrode inférieure et l'électrode précédemment qualifiée d'inférieure devient l'électrode supérieure.

L'élément conducteur monobloc 504 comporte deux branches 504a et 504b présentant sensiblement une forme de parallélépipède rectangle. Les deux branches 504a et 504b sont agencées de manière à présenter une forme en « L ». Préférentiellement, l'angle θ1 entre ces deux branches est compris entre 70 et 110° et plus préférentiellement entre 90° et 110°. Encore plus préférentiellement, l'angle θ1 entre ces deux branches est sensiblement droit, tel que représenté à la figure 4, la première branche 504a définissant une direction $\overrightarrow{X1}$ et la seconde branche 504b définissant une direction $\overrightarrow{Y1}$. Une direction $\overrightarrow{Z1}$ permet alors de définir un repère orthogonal $(\overrightarrow{X1}\,;\,\overrightarrow{Y1}\,;\,\overrightarrow{Z1})$. Les couches s'étendent selon un plan contenant les directions $\overrightarrow{Y1}$ et $\overrightarrow{Z1}$. Préférentiellement, la dimension de la première branche 504a de l'élément conducteur monobloc 504 selon la direction $\overrightarrow{X1}$ est égale ou plus grande que la dimension de la seconde branche 504b de l'élément conducteur monobloc 504 selon la direction $\overrightarrow{Y1}$.

L'élément sélecteur monobloc 503 présente également une forme en « L » avec deux branches 503a et 503b. Préférentiellement, l'angle θ2 entre ces deux branches est compris entre 70 et 110° et plus préférentiellement entre 90° et 110°. Encore plus préférentiellement, l'angle θ2 entre ces deux branches est sensiblement droit, tel que représenté à la figure 4, une première branche 503a de l'élément sélecteur monobloc 503 étant selon la direction $\overrightarrow{X1}$ et possédant une dimension selon la direction $\overrightarrow{X1}$ strictement plus grande que la dimension de la première branche 504a de l'élément conducteur monobloc 504 selon la direction $\overrightarrow{X1}$ et une seconde branche 503b de l'élément sélecteur monobloc 503 étant selon la direction $\overrightarrow{Y1}$ et possédant une dimension selon la direction $\overrightarrow{Y1}$ strictement plus grande que la dimension de la seconde branche 504b de l'élément conducteur monobloc 504 selon la direction $\overrightarrow{Y1}$. Préférentiellement, la dimension de la première branche 503a de l'élément sélecteur monobloc 503 selon la direction $\overrightarrow{X1}$ est égale ou plus grande que la dimension de la seconde branche 503b de l'élément sélecteur monobloc 503 selon la direction $\overrightarrow{Y1}$.

L'élément conducteur monobloc 504 et l'élément sélecteur monobloc 503 sont agencés de manière à former un unique « L », l'élément sélecteur monobloc 503 épousant les contours extérieurs du « L » que constitue l'élément conducteur monobloc 504. L'ensemble E formé de l'élément conducteur monobloc 504 et de l'élément sélecteur monobloc 503 comporte donc deux branches d'ensemble étant sensiblement perpendiculaires, une première branche d'ensemble étant selon la direction $\overrightarrow{X1}$ et possédant une dimension selon la direction $\overrightarrow{X1}$ égale à la dimension de la première branche 503a de l'élément sélecteur monobloc 503 selon la direction X1 et une seconde branche d'ensemble étant selon la direction $\overrightarrow{Y1}$ et possédant une dimension selon la direction $\overrightarrow{Y1}$ égale à la dimension de la seconde branche 503b de l'élément sélecteur monobloc 503 selon la direction $\overrightarrow{Y1}$.

La couche de matériau conducteur d'électrode supérieure de mémoire résistive 509 et l'ensemble E incluant l'élément conducteur monobloc 504 et l'élément sélecteur monobloc 503 sont situés de part et d'autre de la couche active mémoire 508, l'ensemble E étant en contact avec la couche active mémoire 508 au niveau de l'extrémité de la première branche d'ensemble, selon un plan contenant les directions $\overrightarrow{Y1}$ et $\overrightarrow{Z1}$.

La couche active mémoire 508 est donc en contact avec une électrode inférieure au niveau de la surface S1 de contact entre la couche active mémoire 508 et l'extrémité de la première branche 504a de l'élément conducteur monobloc 504 et avec une électrode supérieure au niveau de la surface de contact entre la couche active mémoire 508 et la couche de matériau conducteur d'électrode supérieure de mémoire résistive 509, l'ensemble formé par l'élément conducteur monobloc 504 la couche active mémoire 508 et la couche de matériau conducteur d'électrode supérieure de mémoire résistive 509 formant une mémoire résistive 510.

L'ensemble E est en contact avec la couche de matériau conducteur d'électrode inférieure du dispositif sélecteur 501 au niveau de la face de l'ensemble E définie selon un plan contenant les direction $\overrightarrow{Y1}$ et $\overrightarrow{Z1}$, la plus éloignée de la couche active mémoire 508.

L'élément sélecteur monobloc 503 est donc en contact avec une électrode supérieure au niveau de la surface S2 de contact entre la seconde branche 503b de l'élément sélecteur monobloc 503 et la seconde branche 504b de l'élément conducteur monobloc 504 et avec une électrode inférieure au niveau de la surface de contact entre la seconde branche 503b de l'élément sélecteur monobloc 503 et la couche de matériau conducteur d'électrode inférieure du dispositif sélecteur 501, l'ensemble formé par l'élément conducteur monobloc 504, l'élément sélecteur monobloc 503 et la couche de matériau conducteur d'électrode inférieure du dispositif sélecteur 501 formant le dispositif sélecteur 511.

L'élément sélecteur monobloc 503 pourrait ne pas présenter une forme en « L ». En effet, seule la seconde branche ou couche active sélectrice 503b, en contact à la fois avec l'élément conducteur monobloc 504 et la couche de matériau conducteur d'électrode inférieure du dispositif sélecteur 501 participe au fonctionnement du dispositif sélecteur 511. La première branche 503a de l'élément sélecteur monobloc 503 n'est pas impliquée dans le fonctionnement de la cellule 500 mais, le matériau de la première branche 503a étant peu conducteur, il permet une meilleure isolation de l'élément conducteur monobloc 504.

Le matériau de la couche active mémoire 508 est choisi en fonction du type de mémoire désiré, par exemple, une mémoire de type PCRAM, OxRAM ou encore CBRAM : ce choix conditionne alors le choix des matériaux conducteurs des électrodes de la mémoire. En effet, par exemple, pour qu'une CBRAM fonctionne, il lui faut deux électrodes disposées de part et d'autre de son matériau actif à conduction ionique, dont une électrode comportant une portion de métal ionisable, c'est-à-dire une portion de métal pouvant facilement former des ions métalliques. Le matériau de l'élément conducteur monobloc 503 est choisi en fonction du type de dispositif sélecteur désiré, selon l'invention, un sélecteur de type OTS, FAST ou encore MIEC. Pour une mémoire PCRAM, le matériau de la couche active mémoire 508 est par exemple du GeSbTe, du SbTe ou encore du GeTe. Pour un sélecteur OTS, le matériau de l'élément conducteur monobloc 503 est par exemple du GeSe, du GeSiAsSe, du GeSiAsTe, du AsTe ou encore du GeSeSbN.

Dans le cas d'un sélecteur de type OTS et d'une mémoire résistive de type PCRAM, le matériau utilisé pour l'élément conducteur monobloc 504 est par exemple du TiN, du TaN, du W, du TiWN, du TiSiN ou encore du WN.

Ainsi, la surface de contact entre la couche active mémoire 508 et l'électrode inférieure de la mémoire résistive 510 dépend de la dimension selon la direction $\overrightarrow{Y1}$, de l'extrémité de la première branche 504a de l'élément conducteur monobloc 504 et les dimensions du dispositif sélecteur 511 dépendent de la dimension selon la direction $\overrightarrow{Y1}$, de la face de la seconde branche 504b de l'élément conducteur monobloc 504 étendue selon un plan contenant les directions $\overrightarrow{Y1}$ et $\overrightarrow{Z1}$, la plus éloignée de la couche active mémoire 508, ainsi que de la dimension selon la direction $\overrightarrow{X1}$ de la seconde branche 503b de l'élément conducteur monobloc 503. La forme en « L » de l'élément conducteur monobloc 504 permet donc de découpler les problématiques liées à la réduction de la surface de contact entre la mémoire résistive 510 et son électrode inférieure de celles de la réduction des dimensions du dispositif sélecteur 511.

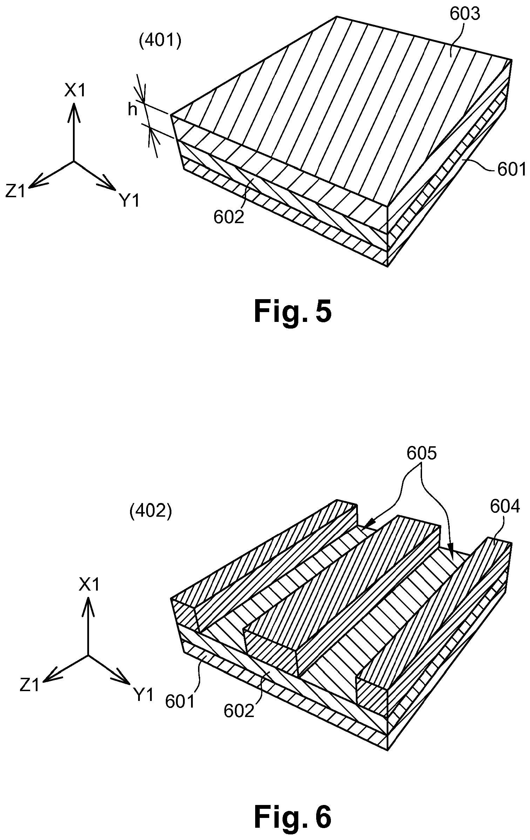

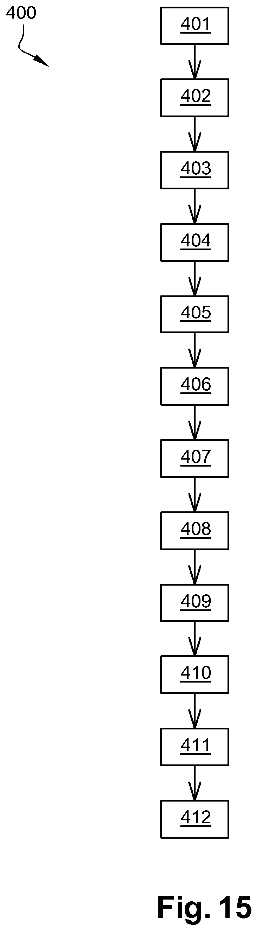

Les figures 5 à 14 illustrent les différentes étapes 401 à 412 (organigramme de la figure 15) du procédé 400 pour la réalisation d'un ou plusieurs étages 600, chaque étage 600 intégrant une pluralité de cellules 500 selon l'invention.

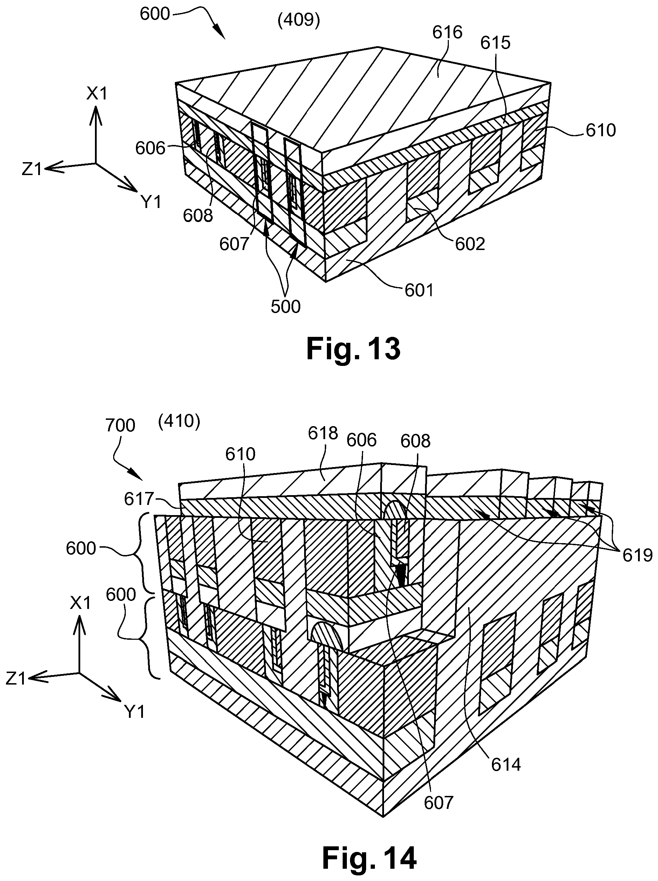

Le procédé 400 permet de fabriquer un étage 600 référencé à la figure 13 comportant une pluralité de cellules élémentaires 500 selon un premier aspect de l'invention et conforme à la cellule 500 de la figure 4, l'étage 600 étant préférentiellement de forme parallélépipédique rectangle.

L'étape 401 de dépôt représentée à la figure 5 consiste à réaliser un dépôt conforme d'une couche de matériau conducteur d'électrode inférieure du dispositif sélecteur 602 sur un substrat 601, puis un dépôt conforme d'une première couche de matériau diélectrique 603 sur la couche de matériau conducteur d'électrode inférieure du dispositif sélecteur 602, dépôt conforme signifiant que le matériau est déposé de manière uniforme sur l'ensemble de la surface du substrat 601 définissant la surface sur laquelle sera formée l'étage 600. Le substrat 601 est constitué d'une ou de plusieurs couches : il comprend, par exemple, une couche avec des lignes en cuivre exposées permettant d'établir des contacts métalliques avec une couche métallique supérieure, non représentée ici. Il comprend ainsi toute la logique nécessaire pour permettre la connexion avec les lignes des couches supérieures. Le plan selon lequel s'étend le substrat 601 contient la direction $\overrightarrow{Y1}$ et la direction $\overrightarrow{Z1}$. Le repère orthogonal ($\overrightarrow{X1}$ ; $\overrightarrow{Y1}$ ; $\overrightarrow{Z1}$) définit les côtés de l'étage 600 s'il est de forme parallélépipédique rectangle. La dimension des couches selon la direction $\overrightarrow{X1}$ est appelée épaisseur. Ainsi, la première couche de matériau diélectrique 603 possède une épaisseur h.

Le matériau diélectrique de la première couche de matériau diélectrique 603 est par exemple du SiN, du SiO$_2$, du SiC, du SiON, du SiCN ou encore SiHN. Les dépôts de cette étape comme ceux des étapes suivantes peuvent être des dépôts CVD (pour « Chemical Vapor Deposition ») ou ALD (pour « Atomic Layer Deposition »).

L'étape 402 de gravure représentée à la figure 6 consiste à graver plusieurs tranchées 605 dans la première couche de matériau diélectrique 603 avec arrêt sur la couche de matériau conducteur d'électrode inférieure du dispositif sélecteur 602. La gravure est par exemple réalisée par photogravure. Les tranchées 605 sont ici suivant la direction $\overrightarrow{Z1}$. Les tranchées 605 sont toutes parallèles entre elles. Une tranchée 605 est gravée de manière à ce que les bords de cette tranchée 605 soient sensiblement de même hauteur et que les flancs de la tranchée 605 soient compris dans des plans orthogonaux au fond de la tranchée 605 contenant la direction $\overrightarrow{X1}$ et sensiblement parallèles entre eux. La profondeur de gravure est sensiblement la même pour toutes les tranchées 605.

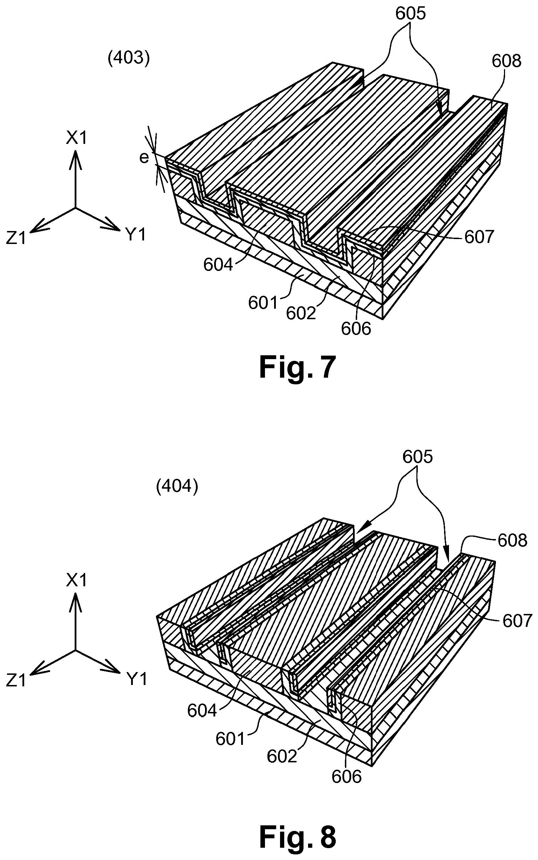

L'étape 403 de dépôt est représentée à la figure 7. Dans un premier temps, une couche active sélectrice 606 est déposée de manière conforme c'est-à-dire sur les tranchées gravées à l'étape de gravure 402 et sur les parties de la première couche de matériau diélectrique n'ayant pas été gravées 604 à l'étape de gravure 402. Ensuite, une couche de matériau d'élément conducteur monobloc 607 est déposée de manière conforme sur la couche active sélectrice 606, puis une deuxième couche de matériau diélectrique 608 est déposée de manière conforme sur la couche de matériau d'élément conducteur monobloc 607. La somme de l'épaisseur de la couche active sélectrice 606, de l'épaisseur de la couche de matériau d'élément conducteur monobloc 607 et de l'épaisseur de la deuxième couche de matériau diélectrique 608 est notée e. Ces épaisseurs doivent préférentiellement respecter certaines conditions. Ainsi, il est préférable que :

- la somme de l'épaisseur de la couche active sélectrice 606 et de la couche de matériau d'élément conducteur monobloc 607 soit strictement inférieure à l'épaisseur h de la première couche de matériau diélectrique 603 pour que l'élément conducteur monobloc 607 puisse présenter une forme en « L » après l'étape de gravure anisotrope 404.
- la somme des épaisseurs e soit strictement inférieure à l'épaisseur h de la première couche de matériau diélectrique 603 pour que les tranchées ne soient pas comblées après les trois dépôts.

Le matériau utilisé pour la deuxième couche de matériau diélectrique 608 est par exemple du SiN, du SiO2, du SiC, du SiON, du SiCN ou encore SiHN.

L'étape 404 de gravure anisotrope représentée à la figure 8 consiste à réaliser une gravure anisotrope selon la direction $\overrightarrow{Z1}$ sur la deuxième couche de matériau diélectrique 608. Au fond des tranchées 605, cette gravure permet un arrêt sur la couche de matériau conducteur d'électrode inférieure du dispositif sélecteur 602 et sur les parties de la première couche de matériau diélectrique qui n'ont pas été gravées 604 lors de l'étape 402 de gravure, un arrêt sur la première couche de diélectrique 603. Il n'y a pas de gravure sur les flancs des tranchées 605 qui restent donc orthogonales au fond des tranchées 605. Cette gravure anisotrope est par exemple, une gravure sèche de type gravure ionique réactive RIE (pour « Reactive-Ion Etching »).

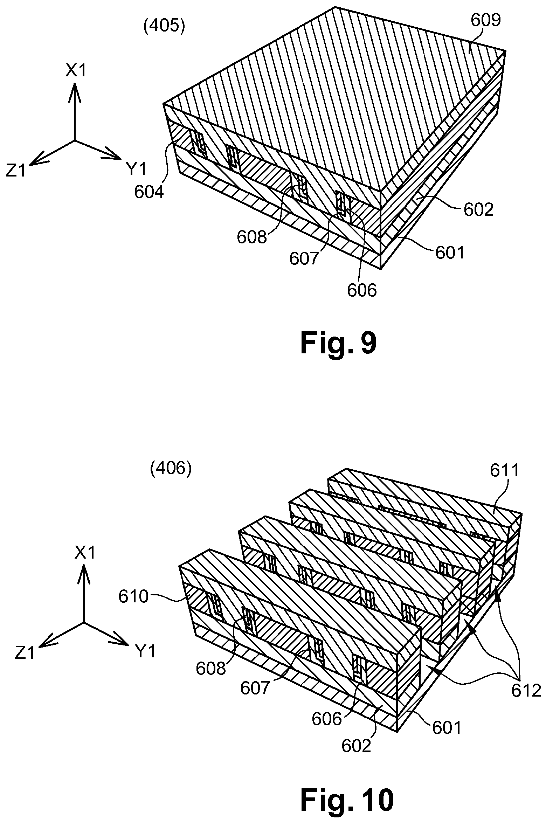

L'étape 405 de remplissage représentée à la figure 9 consiste à remplir les tranchées 605 précédemment gravées et à recouvrir les parties de la première couche de matériau diélectrique n'ayant pas été gravées 604 à l'étape de gravure 402 avec une troisième couche de matériau diélectrique 609. Le matériau de la troisième couche de matériau diélectrique 609 est par exemple du SiN, du SiO2, du SiC, du SiON, du SiCN ou encore SiHN.

L'étape 406 de lithographie représentée à la figure 10 consiste à graver plusieurs tranchées lithographiques 612 suivant une direction, ici suivant $\overrightarrow{Y1}$, perpendiculaire à $\overrightarrow{Z1}$, de manière à graver la couche de matériau conducteur d'électrode inférieure du dispositif sélecteur 602, c'est-à-dire avec arrêt sur le substrat 601. La profondeur de gravure est sensiblement la même pour toutes les tranchées lithographiques 612 et les flancs des tranchées lithographiques 612 sont sensiblement de même hauteur. De plus, les flancs sont orthogonaux au fond des tranchées lithographiques 612, flancs étendus selon des plans contenant la direction $\overrightarrow{X1}$.

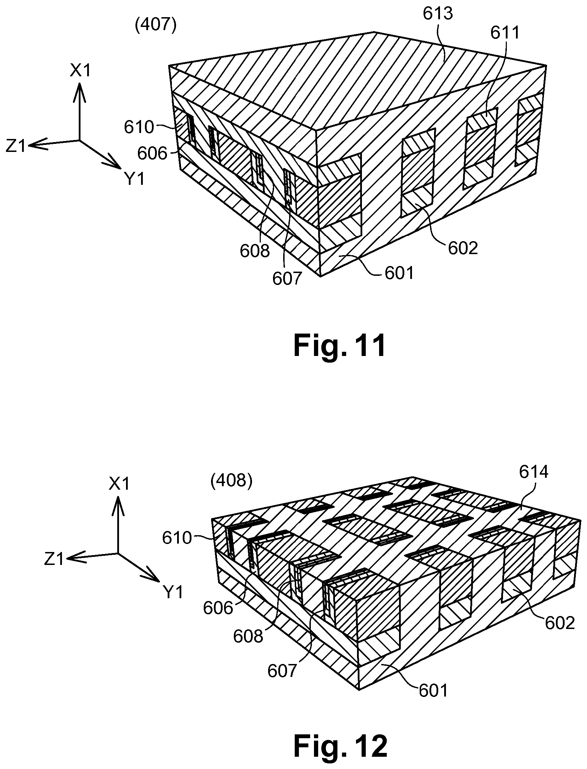

L'étape 407 de remplissage représentée à la figure 11 consiste à remplir les tranchées lithographiques 612 et à recouvrir les parties de la troisième couche de matériau diélectrique n'ayant pas été gravées 611 avec une quatrième couche de matériau diélectrique 613. Le matériau diélectrique de la quatrième couche de matériau diélectrique 613 est par exemple du SiN, du SiO2, du SiC, du SiON, du SiCN ou encore SiHN.

L'étape 408 de planarisation représentée à la figure 12 consiste à retirer de la matière avec arrêt sur les parties de la première couche de matériau diélectrique n'ayant pas été gravées 610 lors de l'étape de gravure 402 et de lithographie 406 de manière à obtenir une couche plane, dans un plan contenant les directions $\overrightarrow{Y1}$ et $\overrightarrow{Z1}$. La planarisation est par exemple un polissage planarisant.

L'étape 409 de dépôt représentée à la figure 13 consiste à réaliser un dépôt conforme d'une couche active mémoire 615 sur les parties de la première couche de matériau diélectrique n'ayant pas été gravées 610 lors de l'étape de gravure 402 et de lithographie 406 puis un dépôt conforme d'une couche de matériau conducteur d'électrode supérieure de mémoire résistive 616 sur la couche active mémoire 615.

On obtient ainsi un étage 600 comportant une pluralité de cellules élémentaires 500, réparties le long de lignes qui correspondent aux flancs des tranchées 605 gravées à l'étape 402 de gravure mais non continument réparties sur ces mêmes lignes à cause des tranchées lithographiques 612 de l'étape 406 de lithographie venues intersecter perpendiculairement les tranchées 605 gravées à l'étape 402 de gravure. Ainsi, une cellule 500 élaborée sur le flanc d'une tranchée 605 a un vis-à-vis sur le flanc opposé de la même tranchée 605 et est séparé d'une autre cellule 500 agencée sur le même flanc de la tranchée 605 par la quatrième couche de matériau diélectrique 614 ayant servi à combler les tranchées lithographiques 612.

Pour réaliser un deuxième étage 600, on dépose la première couche de matériau diélectrique 603 sur la couche de matériau conducteur d'électrode supérieure de mémoire résistive 616 du premier étage 600, c'est-à-dire en considérant la couche de matériau conducteur d'électrode supérieure de mémoire résistive 616 de l'étage 600 précédent comme la couche de matériau conducteur d'électrode inférieure du dispositif sélecteur 602 et en considérant le reste de l'étage comme substrat 601. On réalise ensuite les mêmes opérations que pour le premier étage 600 excepté le fait que les directions de gravure sont alternées c'est-à-dire que les tranchées 605 de l'étape 402 de gravure sont gravées selon la direction $\overrightarrow{Y1}$ et les tranchées lithographiques 612 de l'étape 406 de lithographie selon la direction $\overrightarrow{Z1}$. Autrement dit, si on numérote les étages 600 de la matrice 700, tous les étages numérotés par un multiple de 2 ont des tranchées 605 gravées à l'étape 402 de gravure selon la direction $\overrightarrow{Y1}$ et les tranchées lithographiques 612 selon la direction $\overrightarrow{Z1}$ et tous les autres étages ont des tranchées 605 gravées à l'étape 402 de gravure selon la direction $\overrightarrow{Z1}$ et les tranchées lithographiques 612 selon la direction $\overrightarrow{Y1}$.

Une matrice 700 est un dispositif présentant une pluralité d'étages 600.

Quand le nombre désiré d'étages a été réalisé, une étape de gravure 410 représentée à la figure 14 vient finaliser la matrice. Dans le cas de la figure 14, la matrice 700 comprend deux étages 600. On grave des tranchées finales 619 dans la couche active mémoire 615 et la couche de matériau conducteur d'électrode supérieure de mémoire résistive 616 du dernier étage 600 de manière à ne conserver la couche active mémoire 615 et la couche de matériau conducteur d'électrode supérieure de mémoire résistive 616 qu'au niveau des surfaces de contact entre cette couche active mémoire 615 et les ensembles E formés de l'élément conducteur monobloc 504 et de l'élément sélecteur monobloc 503 de chaque cellule 500 du dernier étage 600. Les cellules 500 du dernier étage 600 sont réparties le long des flancs des tranchées 605 gravées à l'étape 402 de gravure de réalisation du dernier étage 600 donc la direction de gravure des tranchées finales 619 est la même que celles des tranchées 605 réalisées à l'étape 402 de gravure de réalisation du dernier étage 600. Sur la figure 14, les zones de contact entre la couche active mémoire 615 et l'ensemble E incluant l'élément conducteur monobloc 504 et l'élément sélecteur monobloc 503 sont signalées par des demi-cercles.

## Revendications

**1.** Cellule (500) élémentaire comportant une mémoire vive résistive (510) non volatile montée en série avec un dispositif sélecteur (511) volatile, ladite mémoire (510) comportant :

- une électrode supérieure de la mémoire résistive (509),
- une électrode inférieure de la mémoire résistive,
- une couche réalisée dans un premier matériau actif, dite couche active mémoire (508),

ladite mémoire (510) passant d'un état fortement résistif à un état faiblement résistif par application d'une tension seuil entre l'électrode supérieure de la mémoire résistive (509) et l'électrode inférieure de la mémoire résistive, ledit dispositif sélecteur (511) comportant :

- une électrode supérieure du dispositif sélecteur,
- une électrode inférieure du dispositif sélecteur (501),
- une couche réalisée dans un second matériau actif, dite couche active sélectrice (503b),

ledit dispositif sélecteur (511) passant d'un état fortement résistif à un état faiblement résistif par application d'une tension seuil entre l'électrode supérieure du dispositif sélecteur et l'électrode inférieure du dispositif sélecteur (501), ledit dispositif sélecteur (511) repassant à l'état fortement résistif dès que le courant le traversant ou la tension aux bornes de l'électrode supérieure du dispositif sélecteur et l'électrode inférieure du dispositif sélecteur (501) redevient respectivement inférieur à un courant ou une tension de maintien,

ladite cellule (500) comportant un élément conducteur monobloc (504) comportant :

- une première branche (504a) sensiblement en forme de parallélépipède rectangle, ladite première branche (504a) présentant une face en contact avec la surface inférieure de la couche active mémoire (508) afin de former l'électrode inférieure de la mémoire résistive,
- une seconde branche (504b) sensiblement en forme de parallélépipède rectangle, ladite seconde branche (504b) présentant une face en contact avec la surface supérieure de la couche active sélectrice (503b) afin de former l'électrode supérieure du dispositif sélecteur (511) ;

ladite cellule (500) étant **caractérisée en ce que** ladite seconde branche (504b) n'est pas en contact avec la couche active mémoire (508) ; **en ce que le dispositif sélecteur (511) comporte un élément sélecteur monobloc (503) formant la couche active sélectrice (503b) ; et en ce que le matériau de la couche active sélectrice (503b) est choisi de manière à former un dispositif sélecteur (511)** de type « Ovonic Threshold Switching », OTS; « Field Assisted Superlinear Threshold », FAST; ou « Mixed-Ionic-Electronic Conduction », MIEC.

**2.** Cellule (500) selon la revendication 1, **caractérisé**

**en ce que** le dispositif sélecteur (511) comporte un élément sélecteur monobloc (503) comportant :

- une première branche (503a) sensiblement en forme de parallélépipède rectangle, ladite première branche (503a) présentant une face en contact avec une face de la première branche (504a) de l'élément conducteur monobloc (504),
- une seconde branche (503b) sensiblement en forme de parallélépipède rectangle constituée de la couche active sélectrice (503b),

de manière à ce que l'élément sélecteur monobloc (503) épouse les contours extérieurs de l'élément conducteur monobloc (504).

**3.** Cellule (500) selon la revendication 1 ou 2, **caractérisé en ce que** l'angle entre les deux branches de l'élément conducteur monobloc (504) est sensiblement droit.

**4.** Cellule (500) selon l'une quelconque des revendications précédentes, **caractérisé en ce que** la mémoire résistive (510) est de type PCRAM, OxRAM ou CbRAM.

**5.** Etage (600) comportant une pluralité de cellules (500) selon l'une quelconque des revendications précédentes, **caractérisé en ce que** les cellules (500) sont réparties le long de plusieurs droites parallèles entre elles.

**6.** Matrice (700) comportant une pluralité d'étages (600) selon la revendication 5, **caractérisé en ce que** les étages (600) sont agencés les uns sur les autres et la direction des droites selon lesquelles sont réparties les cellules (500) d'un étage (600) alternent d'un étage à l'autre de manière à ce que la direction des droites d'un étage (600) soit perpendiculaire à la direction des droites de l'étage (600) immédiatement en dessous et/ou au-dessus.

**7.** Procédé de fabrication (400) d'un étage (600) selon la revendication 5, **caractérisé en ce qu'**il comporte :

- une étape (401) de dépôt conforme d'une couche de matériau conducteur d'électrode inférieure du dispositif sélecteur (602) sur un substrat (601) puis de dépôt conforme d'une première couche de matériau diélectrique (603) sur la couche de matériau conducteur d'électrode inférieure du dispositif sélecteur (602) ;
- une étape (402) de gravure d'une pluralité de tranchées (605) parallèles entre elles dans la première couche de matériau diélectrique (603) avec arrêt sur la couche de matériau conducteur d'électrode inférieure du dispositif sélecteur (602) ;

- une étape (403) de dépôt conforme d'une couche active sélectrice (606) afin de recouvrir les tranchées (605) et les parties de la première couche de matériau diélectrique qui n'ont pas été gravées (604) lors de l'étape de gravure (402), puis de dépôt conforme d'une couche de matériau d'élément conducteur monobloc (607) sur la couche active sélectrice (606) puis de dépôt conforme d'une deuxième couche de diélectrique (608) sur la couche de matériau d'élément conducteur monobloc (607), de manière à ce que les tranchées (605) ne soient pas comblées ;
- une étape (404) de gravure anisotrope selon la direction des tranchées (605) avec arrêt sur la couche de matériau conducteur d'électrode inférieure du dispositif sélecteur (602) au fond des tranchées (605) et avec arrêt sur les parties de la première couche de matériau diélectrique n'ayant pas été gravées (604) lors de l'étape de gravure (402) afin d'obtenir chaque élément conducteur monobloc (504) des cellules élémentaires (500) ;
- une étape (405) de remplissage par une troisième couche de matériau diélectrique (609) de manière à combler les tranchées (605) ;
- une étape (406) de lithographie réalisant plusieurs tranchées lithographiques (612) suivant une direction perpendiculaire à la direction des tranchées (605) précédemment gravées et dans le plan de la troisième couche de matériau diélectrique (609), avec arrêt sur le substrat (601) ;
- une étape (407) de remplissage par une quatrième couche de matériau diélectrique (613) de manière à combler les tranchées lithographiques (612) ;
- une étape (408) de planarisation avec arrêt sur les parties de la première couche de matériau diélectrique n'ayant pas été gravées (610) ;
- une étape (409) de dépôt conforme d'une couche active mémoire (615) puis de dépôt conforme d'une couche de matériau conducteur d'électrode supérieure de mémoire résistive (616) sur la couche active mémoire (615).

**8.** Procédé de fabrication d'une matrice (700) reprenant les mêmes étapes que le procédé selon la revendication 7 pour chaque étage (600) de la matrice (700), **caractérisé en ce que**, la direction des tranchées (605) d'un étage (600) est perpendiculaire à la direction des tranchées (605) de l'étage (600) immédiatement en dessous et/ou au-dessus.

**9.** Procédé de fabrication d'une matrice (700) selon la revendication 8, caractérisé en qu'il comporte une étape de gravure de plusieurs tranchées finales (619) selon la direction des tranchées (605) gravées à l'étape de gravure (402) de réalisation du dernier étage (600), gravure de tranchées finales dans la couche active mémoire (615) et la couche de matériau conducteur d'électrode supérieure de mémoire résistive (616) du dernier étage (600) de manière à ne conserver la couche active mémoire (615) et la couche de matériau conducteur d'électrode supérieure de mémoire résistive (616) qu'au niveau des surfaces de contact entre la couche active mémoire (615) et la couche de matériau d'élément conducteur monobloc (607).

10. Procédé de fabrication d'au moins une cellule élémentaire comportant une mémoire vive résistive (510) non volatile montée en série avec un dispositif sélecteur (511) volatile, ladite mémoire (510) comportant :

- une électrode supérieure de la mémoire résistive (509),
- une électrode inférieure de la mémoire résistive,
- une couche réalisée dans un premier matériau actif, dite couche active mémoire (508),

ladite mémoire (510) passant d'un état fortement résistif à un état faiblement résistif par application d'une tension seuil entre l'électrode supérieure de la mémoire résistive (509) et l'électrode inférieure de la mémoire résistive, ledit dispositif sélecteur (511) comportant :

- une électrode supérieure du dispositif sélecteur,
- une électrode inférieure du dispositif sélecteur (501),
- une couche réalisée dans un second matériau actif, dite couche active sélectrice (503b),

ledit dispositif sélecteur (511) passant d'un état fortement résistif à un état faiblement résistif par application d'une tension seuil entre l'électrode supérieure du dispositif sélecteur et l'électrode inférieure du dispositif sélecteur (501), ledit dispositif sélecteur (511) repassant à l'état fortement résistif dès que le courant le traversant ou la tension aux bornes de l'électrode supérieure du dispositif sélecteur et l'électrode inférieure du dispositif sélecteur (501) redevient respectivement inférieur à un courant ou une tension de maintien,

le procédé étant **caractérisée en ce qu'**il comporte les étapes suivantes :

- une étape (401) de dépôt conforme d'une couche de matériau conducteur d'électrode inférieure du dispositif sélecteur (602) sur un substrat (601) puis de dépôt conforme d'une première couche de matériau diélectrique (603) sur la couche de matériau conducteur d'électrode inférieure du dispositif sélecteur (602) ;

- une étape (402) de gravure d'au moins une tranchée (605), tranchées parallèles entre elles, dans la première couche de matériau diélectrique (603) avec arrêt sur la couche de matériau conducteur d'électrode inférieure du dispositif sélecteur (602) ;

- une étape (403) de dépôt conforme d'une couche active sélectrice (606) afin de recouvrir chaque tranchée (605) et les parties de la première couche de matériau diélectrique qui n'ont pas été gravées (604) lors de l'étape de gravure (402), puis de dépôt conforme d'une couche de matériau d'élément conducteur monobloc (607) sur la couche active sélectrice (606) puis de dépôt conforme d'une deuxième couche de diélectrique (608) sur la couche de matériau d'élément conducteur monobloc (607), de manière à ce que chaque tranchée (605) ne soit pas comblée ;

- une étape (404) de gravure anisotrope selon la direction de la ou des tranchées (605) avec arrêt sur la couche de matériau conducteur d'électrode inférieure du dispositif sélecteur (602) au fond de la ou des tranchées (605) et avec arrêt sur les parties de la première couche de matériau diélectrique n'ayant pas été gravées (604) lors de l'étape de gravure (402) afin d'obtenir au moins un élément conducteur monobloc (504) ;

- une étape (405) de remplissage par une troisième couche de matériau diélectrique (609) de manière à combler les tranchées (605) ;

- une étape (406) de lithographie réalisant au moins une tranchée lithographique (612) suivant une direction perpendiculaire à la direction de la ou des tranchées (605) précédemment gravées et dans le plan de la troisième couche de matériau diélectrique (609), avec arrêt sur le substrat (601) ;

- une étape (407) de remplissage par une quatrième couche de matériau diélectrique (613) de manière à combler la ou les tranchées lithographiques (612);

- une étape (408) de planarisation avec arrêt sur les parties de la première couche de matériau diélectrique n'ayant pas été gravées (610) ;

- une étape (409) de dépôt conforme d'une couche active mémoire (615) puis de dépôt conforme d'une couche de matériau conducteur d'électrode supérieure de mémoire résistive (616) sur la couche active mémoire (615).

**Patentansprüche**

1. Elementarzelle (500) mit einem nichtflüchtigen resistiven Arbeitsspeicher (510), der in Reihe mit einer flüchtigen Selektorvorrichtung (511) geschaltet ist, wobei der Speicher (510) umfasst:

   - eine obere Elektrode des resistiven Speichers (509),
   - eine untere Elektrode des resistiven Speichers,
   - eine Schicht aus einem ersten aktiven Material, die sogenannte aktive Speicherschicht (508), wobei der Speicher (510) durch Anlegen einer Schwellenspannung zwischen der oberen Elektrode des resistiven Speichers (509) und der unteren Elektrode des resistiven Speichers von einem hochohmigen Zustand in einen niederohmigen Zustand übergeht, wobei die Selektorvorrichtung (511) umfasst:

      - eine obere Elektrode der Selektorvorrichtung,
      - eine untere Elektrode der Selektorvorrichtung (501),
      - eine Schicht aus einem zweiten aktiven Material, die als aktive Selektorschicht (503b) bezeichnet wird,

   wobei die Selektorvorrichtung (511) durch Anlegen einer Schwellenspannung zwischen der oberen Elektrode der Selektorvorrichtung und der unteren Elektrode der Selektorvorrichtung (501) von einem hochohmigen Zustand in einen niederohmigen Zustand übergeht, wobei die Selektorvorrichtung (511) in den hochohmigen Zustand zurückkehrt, sobald der durch sie fließende Strom oder die Spannung an den Anschlüssen der oberen Elektrode der Selektorvorrichtung und der unteren Elektrode der Selektorvorrichtung (501) wieder unter einen Haltestrom bzw. eine Haltespannung fällt, wobei die Zelle (500) ein einteiliges Leiterelement (504) umfasst, das Folgendes umfasst:

      - einen ersten Schenkel (504a), der im Wesentlichen die Form eines rechteckigen Parallelepipeds hat, wobei der erste Schenkel (504a) eine Fläche aufweist, die mit der Unterseite der aktiven Speicherschicht (508) in Kontakt steht, um die untere Elektrode des resistiven Speichers zu bilden,
      - einen zweiten Schenkel (504b), der im Wesentlichen die Form eines rechteckigen Parallelepipeds hat, wobei der zweite Schenkel (504b) eine Fläche aufweist, die mit der Oberseite der aktiven Selektorschicht (503b) in Kontakt steht, um die obere Elektrode der Selektorvorrichtung (511) zu bilden;
   - wobei die Zelle (500) **dadurch gekennzeichnet ist, dass** der zweite Zweig (504b) nicht mit der aktiven Speicherschicht (508) in Kontakt steht; dass die Selektorvorrichtung (511) ein einteiliges Selektionselement (503) umfasst, das die aktive Selektorschicht (503b) bildet; und dass das Material der aktiven Selektorschicht (503b) so gewählt ist, dass es eine Selektorvorrichtung (511) vom Typ "Ovonic Threshold Switching" (OTS), "Field Assisted Superlinear Threshold" (FAST) oder "Mixed-Ionic-Electronic Conduction" (MIEC) bildet.

2. Zelle (500) nach Anspruch 1, **dadurch gekennzeichnet, dass** die Selektorvorrichtung (511) ein einteiliges Selektionselement (503) umfasst, das Folgendes umfasst:

   - einen ersten Schenkel (503a), der im Wesentlichen die Form eines rechteckigen Parallelepipeds hat, wobei der erste Schenkel (503a) eine Fläche aufweist, die mit einer Fläche des ersten Schenkels (504a) des einteiligen Leiterelements (504) in Kontakt steht,
   - einen zweiten Schenkel (503b), der im Wesentlichen die Form eines rechteckigen Parallelepipeds hat und aus der aktiven Selektorschicht (503b) besteht,

   sodass das einteilige Selektionselement (503) sich an die Außenkonturen des einteiligen Leiterelements (504) anpasst.

3. Zelle (500) nach Anspruch 1 oder 2, **dadurch gekennzeichnet, dass** der Winkel zwischen den beiden Schenkeln des einteiligen Leiterelements (504) im Wesentlichen rechtwinklig ist.

4. Zelle (500) nach einem der vorstehenden Ansprüche, **dadurch gekennzeichnet, dass** der resistive Speicher (510) vom Typ PCRAM, OxRAM oder CbRAM ist.

5. Stufe (600) mit einer Vielzahl von Zellen (500) nach einem der vorstehenden Ansprüche, **dadurch gekennzeichnet, dass** die Zellen (500) entlang mehrerer zueinander paralleler Geraden verteilt sind.

6. Matrix (700) mit einer Vielzahl von Stufen (600) gemäß Anspruch 5, **dadurch gekennzeichnet, dass** die Stufen (600) übereinander angeordnet sind und die Richtung der Geraden, entlang derer die Zellen (500) einer Stufe (600) von einer Etage zur nächsten so wechselt, dass die Richtung der Geraden einer Etage (600) senkrecht zur Richtung der Geraden der unmittelbar darunter und/oder darüber liegenden Etage (600) ist.

7. Verfahren zur Herstellung (400) einer Stufe (600) gemäß Anspruch 5, **dadurch gekennzeichnet, dass** es umfasst:

- einen Schritt (401) zum konformen Aufbringen einer Schicht aus leitfähigem Material für die untere Elektrode der Selektorvorrichtung (602) auf ein Substrat (601) und anschließend zum konformen Aufbringen einer ersten Schicht aus dielektrischem Material (603) auf die Schicht aus leitfähigem Material für die untere Elektrode der Selektorvorrichtung (602);
- einen Schritt (402) des Ätzens einer Vielzahl von zueinander parallelen Gräben (605) in die erste Schicht aus dielektrischem Material (603) mit einem Stopp auf der unteren leitfähigen Elektrodenschicht der Selektorvorrichtung (602);
- einen Schritt (403) des konformen Aufbringens einer selektiven aktiven Schicht (606), um die Gräben (605) und die Teile der ersten Schicht aus dielektrischem Material, die beim Ätzschritt (402) nicht geätzt wurden (604), zu bedecken, anschließendes konformes Aufbringen einer Schicht aus einem einteiligen leitenden Elementmaterial (607) auf die selektive aktive Schicht (606) und anschließendes konformes Aufbringen einer zweiten dielektrischen Schicht (608) auf die Schicht aus einem einteiligen leitenden Elementmaterial (607), sodass die Gräben (605) nicht aufgefüllt werden;
- einen Schritt (404) des anisotropen Ätzens in Richtung der Gräben (605) mit einem Stopp auf der leitenden Materialschicht der unteren Elektrode der Selektorvorrichtung (602) am Boden der Gräben (605) und mit einem Stopp auf den Teilen der ersten Schicht aus dielektrischem Material, die beim Ätzschritt (402) nicht geätzt wurden (604), um jedes einteilige Leiterelement (504) der Elementarzellen (500) zu erhalten;
- einen Schritt (405) des Füllens mit einer dritten Schicht aus dielektrischem Material (609), um die Gräben (605) zu füllen;
- einen Lithografieschritt (406), bei dem mehrere lithografische Gräben (612) in einer Richtung senkrecht zur Richtung der zuvor geätzten Gräben (605) und in der Ebene der dritten Schicht aus dielektrischem Material (609) hergestellt werden, wobei auf dem Substrat (601) angehalten wird;
- einen Füllschritt (407) mit einer vierten Schicht aus dielektrischem Material (613), um die lithografischen Gräben (612) zu füllen;
- einen Schritt (408) zum Planarisieren mit Stopp auf den nicht geätzten Teilen der ersten Schicht aus dielektrischem Material (610);
- einen Schritt (409) des konformen Aufbringens einer aktiven Speicherschicht (615) und anschließend des konformen Aufbringens einer Schicht aus leitfähigem Material für die obere Elektrode des resistiven Speichers (616) auf die aktive Speicherschicht (615).

8. Verfahren zur Herstellung einer Matrix (700), das für jede Stufe (600) der Matrix (700) die gleichen Schritte wie das Verfahren gemäß Anspruch 7 umfasst, **dadurch gekennzeichnet, dass** die Richtung der Gräben (605) einer Stufe (600) senkrecht zur Richtung der Gräben (605) der unmittelbar darunter und/oder darüber liegenden Stufe (600) ist.

9. Verfahren zur Herstellung einer Matrix (700) gemäß Anspruch 8, **dadurch gekennzeichnet, dass** es einen Schritt zum Ätzen mehrerer Endgräben (619) in Richtung der Gräben (605) umfasst, die im Ätzschritt (402) zur Herstellung der letzten Stufe (600) geätzt wurden, Ätzen von Endgräben in die aktive Speicherschicht (615) und die Schicht aus leitfähigem Material der oberen Elektrode des resistiven Speichers (616) der letzten Stufe (600) derart, dass die aktive Speicherschicht (615) und die Schicht aus leitendem Material der oberen Elektrode des resistiven Speichers (616) nur auf Höhe der Kontaktflächen zwischen der aktiven Speicherschicht (615) und der Schicht aus einteiligem leitendem Elementmaterial (607) erhalten bleiben.

10. Verfahren zur Herstellung mindestens einer Elementarzelle mit einem nichtflüchtigen resistiven Arbeitsspeicher (510), der in Reihe mit einer flüchtigen Selektorvorrichtung (511) geschaltet ist, wobei der Speicher (510) umfasst:

- eine obere Elektrode des resistiven Speichers (509),
- eine untere Elektrode des resistiven Speichers,
- eine Schicht aus einem ersten aktiven Material, die sogenannte aktive Speicherschicht (508), wobei der Speicher (510) durch Anlegen einer Schwellenspannung zwischen der oberen Elektrode des resistiven Speichers (509) und der unteren Elektrode des resistiven Speichers von einem hochohmigen Zustand in einen niederohmigen Zustand übergeht, wobei die Selektorvorrichtung (511) umfasst:

- eine obere Elektrode der Selektorvorrichtung,

- eine untere Elektrode der Selektorvorrichtung (501),
- eine Schicht aus einem zweiten aktiven Material, die als aktive Selektorschicht (503b) bezeichnet wird,

wobei die Selektorvorrichtung (511) durch Anlegen einer Schwellenspannung zwischen der oberen Elektrode der Selektorvorrichtung und der unteren Elektrode der Selektorvorrichtung (501) von einem hochohmigen Zustand in einen niederohmigen Zustand übergeht, wobei die Selektorvorrichtung (511) in den hochohmigen Zustand zurückkehrt, sobald der durch sie fließende Strom oder die Spannung an den Anschlüssen der oberen Elektrode der Selektorvorrichtung und der unteren Elektrode der Selektorvorrichtung (501) wieder unter einen Haltestrom bzw. eine Haltespannung fällt,

wobei das Verfahren **dadurch gekennzeichnet ist, dass** es die folgenden Schritte umfasst:

- einen Schritt (401) des konformen Aufbringens einer Schicht aus leitfähigem Material der unteren Elektrode der Selektorvorrichtung (602) auf ein Substrat (601) und anschließend des konformen Aufbringens einer ersten Schicht aus dielektrischem Material (603) auf die Schicht aus leitfähigem Material der unteren Elektrode der Selektorvorrichtung (602);
- einen Schritt (402) des Ätzens mindestens eines Grabens (605), von zueinander parallelen Gräben, in die erste Schicht aus dielektrischem Material (603) mit einem Stopp auf der unteren Elektrodenleiterschicht der Selektorvorrichtung (602);
- einen Schritt (403) des konformen Aufbringens einer aktiven Selektorschicht (606), um jeden Graben (605) und die Teile der ersten Schicht aus dielektrischem Material, die während des Ätzschritts (402) nicht geätzt wurden (604), zu bedecken, anschließendes konformes Aufbringen einer Schicht aus einem einteiligen leitenden Elementmaterial (607) auf die aktive Selektorschicht (606) und anschließendes konformes Aufbringen einer zweiten dielektrischen Schicht (608) auf die Schicht aus einem einteiligen leitenden Elementmaterial (607), so dass jeder Graben (605) nicht aufgefüllt wird;
- einen Schritt (404) des anisotropen Ätzens in Richtung des oder der Gräben (605) mit einem Stopp auf der unteren Elektrodenleiterschicht der Selektorvorrichtung (602) am Boden des oder der Gräben (605) und mit einem Stopp auf den Teilen der ersten Schicht aus dielektrischem Material, die während des Ätzschritts (402) nicht geätzt wurden (604), um mindestens ein einteiliges Leiterelement (504) zu erhalten;
- einen Füllschritt (405) mit einer dritten Schicht aus dielektrischem Material (609), um die Gräben (605) zu füllen;
- einen Lithografieschritt (406), bei dem mindestens ein lithografischer Graben (612) in einer Richtung senkrecht zur Richtung des oder der zuvor geätzten Gräben (605) und in der Ebene der dritten Schicht aus dielektrischem Material (609) hergestellt wird, wobei auf dem Substrat (601) angehalten wird;
- einen Füllschritt (407) mit einer vierten Schicht aus dielektrischem Material (613), um den oder die lithografischen Gräben (612) zu füllen;
- einen Schritt (408) zum Planarisieren mit Stopp an den nicht gravierten Teilen der ersten Schicht aus dielektrischem Material (610);
- einen Schritt (409) des konformen Aufbringens einer aktiven Speicherschicht (615) und anschließend des konformen Aufbringens einer Schicht aus leitfähigem Material für die obere Elektrode des resistiven Speichers (616) auf die aktive Speicherschicht (615).

**Claims**

1. Elementary cell (500) comprising a non-volatile resistive random-access memory (510) mounted in series with a volatile selector device (511), said memory (510) comprising:

    - an upper electrode of the resistive random-access memory (509),
    - a lower electrode of the resistive random-access memory,
    - a layer made of a first active material, designated memory active layer (508),
    said memory (510) going from a high resistance state to a low resistance state by application of a threshold voltage between the upper electrode of the resistive random-access memory (509) and the lower electrode of the resistive random-access memory, said selector device (511) comprising:

        - an upper electrode of the selector device,
        - a lower electrode of the selector device (501),
        - a layer made of a second active material, designated selector active layer (503b),

said selector device (511) going from a high resistance state to a low resistance state by application of a threshold voltage between the upper electrode of the selector device and the lower electrode of the selector device (501), said selector device (511) returning to the high resistance state as soon as the current flowing through it or the voltage at the terminals of the upper electrode of the selector device and the lower electrode of the selector device (501) returns respectively below a holding current or voltage,

said cell (500) comprising a one-piece conductor element (504) comprising:

- a first branch (504a) of substantially rectangular parallelepiped shape, said first branch (504a) having one face in contact with the lower surface of the memory active layer (508) in order to form the lower electrode of the resistive random-access memory,
- a second branch (504b) of substantially rectangular parallelepiped shape, said second branch (504b) having one face in contact with the upper surface of the selector active layer (503b) in order to form the upper electrode of the selector device (511),

said cell being **characterized in that** said second branch (504b) is not in contact with the memory active layer (508) and **in that** selector device (511) comprises a one-piece selector element (503) forming the selector active layer (503b) and **in that** the material of the selector active layer (503b) is chosen in order to form a selector device (511) of the "Ovonic Threshold Switching" OTS, "Field Assisted Superlinear Threshold" FAST or "Mixed-Ionic-Electronic Conduction" MIEC type.

2. Cell (500) according to claim 1, **characterised in that** the selector device (511) comprises a one-piece selector element (503) comprising:

- a first branch (503a) of substantially rectangular parallelepiped shape, said first branch (503a) having one face in contact with one face of the first branch (504a) of the one-piece conductor element (504),
- a second branch (503b) of substantially rectangular parallelepiped shape constituted of the selector active layer (503b),

in such a way that the one-piece selector element (503) feats the outlines of the one-piece conductor element (504).

3. Cell (500) according to claim 1 or 2, **characterised in that** the angle between the two branches of the one-piece conductor element (504) is substantially a right angle.

4. Cell (500) according to any of the preceding claims, **characterised in that** the resistive random-access memory (510) is of PCRAM, OxRAM or CbRAM type.

5. Stage (600) comprising a plurality of cells (500) according to any of the preceding claims, **characterised in that** the cells (500) are distributed along several straight lines parallel with each other.

6. Matrix (700) comprising a plurality of stages (600) according to claim 5, **characterised in that** the stages (600) are laid out one on top of the other and the direction of the straight lines along which are distributed the cells (500) of a stage (600) alternate from one stage to the next in such a way that the direction of the straight lines of a stage (600) is perpendicular to the direction of the straight lines of the stage (600) immediately below and/or above.

7. Method for manufacturing (400) a stage (600) according to claim 5, **characterised in that** it comprises:

- a step (401) of conformal deposition of a conductor material layer of the lower electrode of the selector device (602) on a substrate (601) then of conformal deposition of a first dielectric material layer (603) on the conductor material layer of the lower electrode of the selector device (602);
- a step (402) of etching a plurality of trenches (605) parallel with each other in the first dielectric material layer (603) with stoppage on the conductor material layer of the lower electrode of the selector device (602);
- a step (403) of conformal deposition of a selector active layer (606) in order to cover the trenches (605) and the parts of the first dielectric material layer that have not been etched (604) during the etching step (402), then of conformal deposition of a material layer of the one-piece conductor element (607) on the selector active layer (606) then of conformal deposition of a second dielectric layer (608) on the material layer of the one-piece conductor element (607), in such a way that the trenches (605) are not filled;
- a step (404) of anisotropic etching along the direction of the trenches (605) with stoppage on the conductor material layer of the lower electrode of the selector device (602) at the bottom of the trenches (605) and with stoppage on the parts of the first dielectric material layer not having been etched (604) during the etching step (402) in order to obtain each one-piece conductor element (504) of the elementary cells (500);

- a step (405) of filling with a third dielectric material layer (609) so as to fill the trenches (605);

- a step (406) of lithography producing several lithographic trenches (612) along a direction perpendicular to the direction of the trenches (605) etched previously and in the plane of the third dielectric material layer (609), with stoppage on the substrate (601);

- a step (407) of filling with a fourth dielectric material layer (613) so as to fill the lithographic trenches (612);

- a step (408) of planarization with stoppage on the parts of the first dielectric material layer not having been etched (610);

- a step (409) of conformal deposition of a memory active layer (615) then of conformal deposition of a conductor material layer of the upper electrode of the resistive random-access memory (616) on the memory active layer (615).

8. Method for manufacturing a matrix (700) reproducing the same steps as the method according to claim 7 for each stage (600) of the matrix (700), **characterised in that** the direction of the trenches (605) of a stage (600) is perpendicular to the direction of the trenches (605) of the stage (600) immediately below and/or above.

9. Method for manufacturing a matrix (700) according to claim 8, **characterised in that** it comprises a step of etching several final trenches (619) along the direction of the trenches (605) etched at the etching step (402) for producing the final stage (600), etching of final trenches in the memory active layer (615) and the conductor material layer of the upper electrode of the resistive random-access memory (616) of the final stage (600) so as to only conserve the memory active layer (615) and the conductor material layer of the upper electrode of the resistive random-access memory (616) at the level of the contact surfaces between the memory active layer (615) and the material layer of the one-piece conductor element (607).

10. Method for manufacturing at least one elementary cell comprising a non-volatile resistive random-access memory (510) mounted in series with a volatile selector device (511), said memory (510) comprising:

- an upper electrode of the resistive random-access memory (509),

- a lower electrode of the resistive random-access memory,

- a layer made of a first active material, designated memory active layer (508),

said memory (510) going from a high resistance state to a low resistance state by application of a threshold voltage between the upper electrode of the resistive random-access memory (509) and the lower electrode of the resistive random-access memory, said selector device (511) comprising:

- an upper electrode of the selector device,
- a lower electrode of the selector device (501),
- a layer made of a second active material, designated selector active layer (503b),

said selector device (511) going from a high resistance state to a low resistance state by application of a threshold voltage between the upper electrode of the selector device and the lower electrode of the selector device (501), said selector device (511) returning to the high resistance state as soon as the current flowing through it or the voltage at the terminals of the upper electrode of the selector device and the lower electrode of the selector device (501) returns respectively below a holding current or voltage,

the method being **characterised in that** it comprises the following steps:

- a step (401) of conformal deposition of a conductor material layer of the lower electrode of the selector device (602) on a substrate (601) then of conformal deposition of a first dielectric material layer (603) on the conductor material layer of the lower electrode of the selector device (602);

- a step (402) of etching at least one trench (605), the trenches being parallel with each other, in the first dielectric material layer (603) with stoppage on the conductor material layer of the lower electrode of the selector device (602);

- a step (403) of conformal deposition of a selector active layer (606) in order to cover each trench (605) and the parts of the first dielectric material layer that have not been etched (604) during the etching step (402), then of conformal deposition of a material layer of the one-piece conductor element (607) on the selector active layer (606) then of conformal deposition of a second dielectric layer (608) on the material layer of the one-piece conductor element (607), in such a way that each trench (605) is not filled;

- a step (404) of anisotropic etching along the direction of the trench(es) (605) with stoppage on the conductor material layer of the lower electrode of the selector device (602) at the bottom of the trench(es) (605) and with stoppage on the parts of the first dielectric material layer not having been etched (604) during the etching step (402) in order to obtain at least one one-piece conductor element (504);

- a step (405) of filling with a third dielectric material layer (609) so as to fill the trenches (605);

- a step (406) of lithography producing at least one lithographic trench (612) along a direction perpendicular to the direction of the trench(es) (605) etched previously and in the plane of the third dielectric material layer (609), with stoppage on the substrate (601);

- a step (407) of filling with a fourth dielectric material layer (613) so as to fill the lithographic trench(es) (612);

- a step (408) of planarization with stoppage on the parts of the first dielectric material layer not having been etched (610);

- a step (409) of conformal deposition of a memory active layer (615) then of conformal deposition of a conductor material layer of the upper electrode of the resistive random-access memory (616) on the memory active layer (615).

**Fig. 1**

**Fig. 2**

**Fig. 3**

**Fig. 4**

(401)

603

X1

Z1   Y1

h

601

602

## Fig. 5

(402)

605

604

X1

Z1   Y1

601   602

## Fig. 6

**Fig. 7**

**Fig. 8**

(405)

609

X1

Z1    Y1

604

608

607

606

602

601

**Fig. 9**

(406)

611

X1

Z1    Y1

610

608

607

606

602

601

612

**Fig. 10**

**Fig. 11**

**Fig. 12**

**Fig. 13**

**Fig. 14**

400

```
┌─────────┐
│   401   │
└─────────┘
     │
     ▼
┌─────────┐
│   402   │
└─────────┘
     │
     ▼
┌─────────┐
│   403   │
└─────────┘
     │
     ▼
┌─────────┐
│   404   │
└─────────┘
     │
     ▼
┌─────────┐
│   405   │
└─────────┘
     │
     ▼
┌─────────┐
│   406   │
└─────────┘
     │
     ▼
┌─────────┐
│   407   │
└─────────┘
     │
     ▼
┌─────────┐
│   408   │
└─────────┘
     │
     ▼
┌─────────┐
│   409   │
└─────────┘
     │
     ▼
┌─────────┐
│   410   │
└─────────┘
     │
     ▼
┌─────────┐
│   411   │
└─────────┘
     │
     ▼
┌─────────┐
│   412   │
└─────────┘
```

**Fig. 15**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20150123066 A1
- US 20140312296 A1
- US 20100227438 A1
- US 20130270507 A1
- WO 2016043657 A1